# EUROPEAN PATENT SPECIFICATION

(11) **EP 0 447 850 B1**
(45) Date of publication and mention of the grant of the patent: **18.12.1996**
(21) Application number: 91102978.3
(22) Date of filing: 27.02.1991
(51) Int. Cl.: C23C 14/08, C23C 14/35

(54) **Method and apparatus for producing transparent conductive film**
Verfahren und Vorrichtung zum Herstellen eines durchsichtigen leitenden Films
Méthode et appareillage de production d'un film transparent conducteur

(30) Priority: 27.02.1990 JP 44558/90
(43) Date of publication of application: 25.09.1991
(73) Proprietor: NIHON SHINKU GIJUTSU KABUSHIKI KAISHA, Chigasaki-shi Kanagawa-ken (JP)
(72) Inventor: Ishibashi, Satoru, Nihon Shinku Gijutsu K.K., Chigasaki-shi, Kanagawa-ken (JP); Nakamura, Kyuzo, Nihon Shinku Gijutsu K.K., Chigasaki-shi, Kanagawa-ken (JP); Higuchi, Yasushi, Nihon Shinku Gijutsu K.K., Chigasaki-shi, Kanagawa-ken (JP); Komatsu, Takashi, Nihon Shinku Gijutsu K.K., Chigasaki-shi, Kanagawa-ken (JP); Murata, Yuzo, Nihon Shinku Gijutsu K.K., Chigasaki-shi, Kanagawa-ken (JP); Ota, Yoshifumi, Nihon Shinku Gijutsu K.K., Chigasaki-shi, Kanagawa-ken (JP)
(74) Representative: Schmidt-Evers, Jürgen, Dipl.-Ing.

(56) References cited:
- EP-A- 0 115 629
- EP-A- 0 416 241
- EP-A- 0 421 015
- US-A- 4 500 408
- ELECTRONICS AND COMMUNICATIONS IN JAPAN vol. 56-C, no. 4, 1973, NEW YORK US pages 74 - 79 Y. SHINTANI ET AL. 'BaTiO3 films by RF sputtering'
- APPLIED PHYSICS LETTERS vol. 41, no. 10, 1982, NEW YORK US pages 958 - 960 T. Minami et al. "Highly conductive and transparent zinc oxide films prepared by rf magnetron sputtering under an applied external magnetic field

## Description

### BACKGROUND OF THE INVENTION

This invention relates to a method and an apparatus for producing a transparent conductive film and in particular to a method and an apparatus for producing an In-O, Sn-O, Zn-O, Cd-Sn-O or Cd-In-O based transparent conductive film used as an electrode for a liquid crystal display element or the like and a solar battery or the like.

There are conventionally known methods of producing this kind of transparent conductive film such as coating, vacuum deposition, and gas-phase reaction methods as well as sputtering methods including a DC or RF double-pole sputtering method and a DC or RF magnetron sputtering method. Among these producing methods, the sputtering methods are superior to the other producing methods in that a transparent conductive film of relatively low electric resistance is easily obtained and that this transparent conductive film can be formed uniformly and well controllably on a large-sized substrate with a good reproducibility or repeatability. Among the producing methods by these sputtering methods, the magnetron sputtering method which utilizes plasma confinement by a magnetic field on a surface of a target is generally used because it has a large film-forming speed and is superior for mass production. Further, as an electric power supply for generating electric discharging, a DC power supply is normally used because it is superior in points of cost, uniformity of electric discharging, film-forming speed or the like.

In the method of producing a transparent conductive film by sputtering methods, the temperature of a substrate and the partial pressure of oxygen are known as factors which affect the electrical resistivity of the transparent conductive film. As regards the substrate temperature, it is known that the higher the substrate temperature, the lower the electrical resistivity of the resulting film. On the other hand, as regards the partial pressure of oxygen, it is known that in a region of lower oxygen partial pressure, the density of a carrier is larger, and the mobility is smaller because there are many vacancies of oxygen as a donor in such a region. Whereas in a region of higher oxygen partial pressure, the density of a carrier is smaller and the mobility is larger. Thus, there is an optimum partial pressure of oxygen that will result in an electrical resistivity of a minimum value from an even balance of the density and the mobility. Thus, it was a practice in the prior art sputtering methods to produce a transparent conductive film having a lower electrical resistivity wherein parameters of the substrate temperature and the partial pressure of oxygen were controlled.

However, it is required in the present-day display element that the transparent electrode have a lower electric resistance because of enlargement of a display screen size. The prior art sputtering methods can no longer meet the requirements. Especially, in a display element of simple matrix drive system, a transparent conductive film is used in the scanning signal electrode. If the electric resistance of the transparent conductive film is high, the image quality is deteriorated. Therefore, the electric resistance of the transparent conductive film must be low. In addition, in a full color STN display element which is attracting attention recently, a transparent conductive film is normally formed on an organic color filter. Therefore, the temperature of forming the transparent conductive film is limited to about 160 to 200°C due to the heat-resisting temperature of the filter, and a requirement for forming the transparent conductive film at a lower temperature is getting stronger.

The inventors of this invention already found out, as disclosed in Japanese Patent Application No. 150086/1989 (Japanese Published Unexamined Patent Application No. 232358/1990), that the factors largely affecting the electrical resistivity in producing a transparent conductive film by sputtering methods are the discharging voltage during sputtering, aside from the above-described substrate temperature and the partial pressure of oxygen. Consequently, a method of producing a transparent conductive film was proposed in which a transparent conductive film of lower resistance can be obtained by sputtering at a low sputtering voltage. This method is based on the following idea. Namely, when a transparent oxide conductive film is formed by a sputtering method, anions of oxygen are generated by ionization of oxygen in the introduced oxygen gas or a target composition. These anions smash into a substrate, thereby giving micro-damages to the transparent conductive film that is being formed and consequently deteriorating the film characteristics such as resistance or the like. Since these anions are accelerated by an electric field to be generated by the negative electric potential of the target, the degree to which the formed transparent conductive film is deteriorated is proportional to the energy of the anions, i.e., the negative electric potential of the target.

Here, the target during sputtering is understood to be in the negative electric potential and an absolute value thereof is called a sputtering voltage or a discharging voltage.

In the producing method of the above-described patent application, the intensity of a magnetic field on the surface of the target was increased and the density of plasma by magnetron discharging was increased, resulting in a decrease or lowering in the electric discharging voltage. By lowering the sputtering voltage down to about 250V in the above-described method while that in the conventional DC magnetron sputtering method is about 400V (the target electric potential is -400V), it was possible to largely decrease the electrical resistivity of the formed transparent conductive films which were produced at various substrate temperatures ranging from the room temperature to 400°C or above. The electrical resistivity of the transparent conductive film at that time linearly dropped relative to the sputtering voltage within the sputtering voltage range of 400 to 250V. It was expected that the electrical resistivity would further lower also in the range of the sputtering voltage of 250V or below.

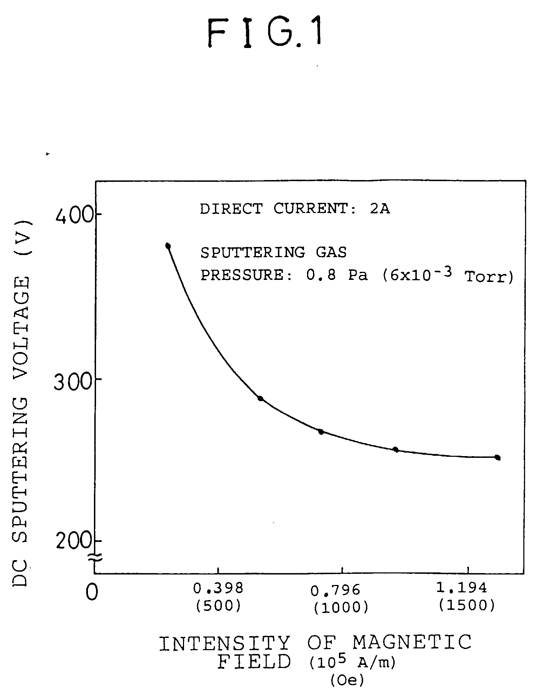

However, in the above-described method of controlling the sputtering voltage by varying only the intensity of the magnetic field, it is difficult to lower the sputtering voltage below 250V as can be seen from Fig. 1 which shows the relationship between the intensity of the magnetic field on the surface of the target and the discharging voltage during sputtering. Namely, up to about 0.796 x 10⁵ A/m (1000 Oe) the sputtering voltage effectively decreases with the increase in the intensity of the magnetic field. Above 0.796 x 10⁵ A/m (1000 Oe), however, the decrease in the sputtering voltage is almost saturated, and the sputtering voltage becomes about 250V at 1.273 x 10⁵ A/m (1600 Oe). As a consequence, even though the intensity of the magnetic field is further increased, the decrease in the sputtering voltage cannot be expected any more.

Therefore, this invention has an object, by eliminating the problems associated with the conventional methods, of providing a method of and an apparatus for producing a transparent conductive film with still lower electric resistance.

### SUMMARY OF THE INVENTION

Upon diligent studies to attain the above-described object, the inventors of this invention have found that the sputtering voltage can further be lowered or decreased by superimposing an RF electric field on a DC electric field for discharging purpose while, at the same time, increasing the intensity of the magnetic field on the surface of the target.

This invention has been made on the basis of the above-described finding. This invention is a method of producing an In-O, Sn-O, Zn-O, Cd-Sn-O or Cd-In-O based transparent conductive film with an optional addition of a donor element, wherein the sputtering is carried out by maintaining an intensity of a magnetic field on a surface of a target at a level of 0.477 x 10⁵ A/m (600 Oe) or greater and sputtering the target so as to form the transparent conductive film on a substrate by charging the target, simultaneously with said maintaining of the magnetic field intensity, with a DC electric field superimposed with an RF electric field so as to lower the sputtering voltage to 250 volts or less.

As explained above with reference to Fig. 1, when only the magnetic field is varied, the lowering or decrease in the sputtering voltage is saturated around 0.796 x 10⁵ A/m (1000 Oe) and, consequently, it is difficult to lower the sputtering voltage below 250V. In order to further lower the sputtering voltage, the density of plasma may be increased. By increasing the density of plasma, the plasma impedance is lowered and the discharging voltage is lowered. The inventors of this invention succeeded in largely lowering the sputtering voltage below 250V by superimposing, as a means of increasing the density of plasma, the RF electric field on the DC electric field for generating the discharging. Here, the superimposition of the RF electric field is effective when the intensity of the magnetic field on the surface of the target is 0.477 x 10⁵ A/m (600 Oe) or more. When the intensity of the magnetic field is below 0.477 x 10⁵ A/m (600 Oe), the sputtering voltage contrarily increases by the superimposition of the RF electric field. Therefore, in superimposing the high-frequency electric filed, the intensity of the magnetic field on the surface of the target must be maintained at 0.477 x 10⁵ A/m (600 Oe) or greater.

As the above-described target, an In, Sn, Zn, Cd-Sn, Cd-In based metallic target or the like or its sintered oxide based target with an addition, depending on necessity, of a donor element is used. As an element to be added, Sn is generally used for an In-O based target, Sb for an Sn-O based target, In, Al, Si or the like for a Zn-O based target, respectively. Among these targets, the In-O based target with an addition of a small amount of Sn (hereinafter called as ITO) results in a film of the lowest resistance value. In addition, it is superior in the etching characteristics of the resultant film. It is therefore preferable to use the ITO target.

The target may be of a sintered oxide target, and a DC power supply can be used as the electric discharging power supply because the sintered oxide target itself has a high electric conductivity.

As a sputtering gas, a mixture gas of an inert gas such, for example, as Ar or the like added by oxygen may be used. When Ar is used as the inert gas, it is preferable to make the mixture gas pressure to the order of about 0.133 Pa (10⁻³ Torr), and the oxygen partial pressure to the order of about 0.001 Pa (10⁻⁵ Torr).

Another aspect of this invention is an apparatus for producing an In-O, Sn-O, Zn-O, Cd-Sn-O or Cd-In-O based transparent conductive film with an optional addition of a donor element, the apparatus having a vacuum chamber adapted to support therein a substrate and a target in an opposed relationship to each other for forming by sputtering the transparent conductive film on the substrate by plasma discharge generated therebetween, wherein the apparatus comprises means for forming a magnetic field having a predetermined intensity of 0.477 x 10⁵ A/m (600 Oe) or greater on a surface of the target, and power supply means for sputtering used in forming the transparent conductive film, said power supply means including DC power supply means for charging the target with a DC electric field, and RF power supply means for charging the target with a RF electric field superimposed on the DC electric field, said power supply means so constructed and arranged as to supply an electric field to the target by superimposing the RF electric field on the DC electric field while maintaining a sputtering voltage during formation of the transparent conductive film at 250 volts or less.

According to this invention, it is possible to sputter at a sputtering voltage of 250V or less. Therefore, the energy of the anions of oxygen to be incident on the substrate is kept low, resulting in a smaller damage to the transparent conductive film. A transparent conductive film of lower electric resistance can thus be obtained.

### BRIEF DESCRIPTION OF THE DRAWINGS

The above and other objects and the attendant advantages of this invention will become readily apparent by reference to the following detailed description when considered in conjunction with the accompanying drawings wherein:
Fig. 1 is a characteristic graph showing the relationship between the intensity of magnetron magnetic field and the DC sputtering voltage;
Fig. 2 is a sectional view of an apparatus for producing a transparent conductive film according to one embodiment of this invention;
Fig. 3 is a characteristic graph showing the relationship between the superimposed RF electric power and the DC sputtering voltage;
Fig. 4 is a graph showing the relationship between the superimposed RF electric power and the DC sputtering voltage at varying intensities of the magnetron magnetic field; and
Fig. 5 is a graph showing the relationship between the DC sputtering voltage and the electrical resistivity of ITO transparent conductive film.

### DETAILED DESCRIPTION OF A PREFERRED EMBODIMENT

A method and an apparatus for producing a transparent conductive film according to a preferred embodiment of this invention will now be described with reference to the accompanying drawings.

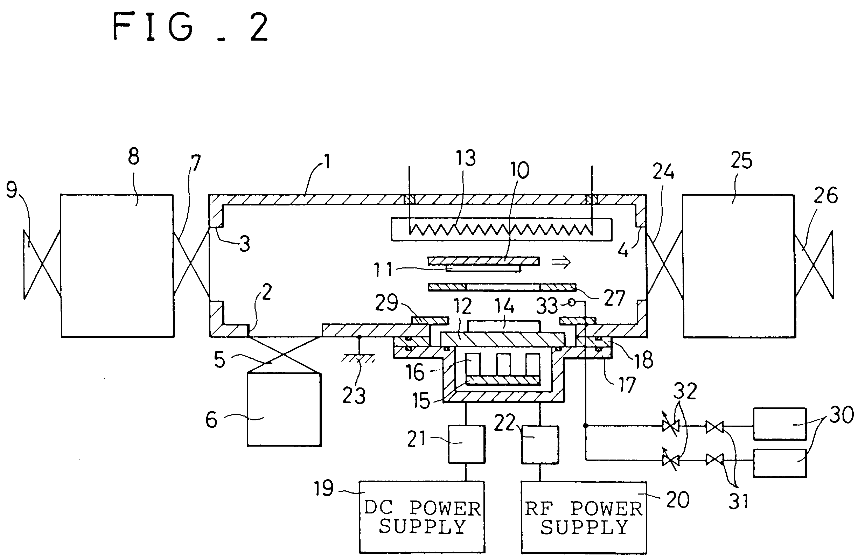

Fig. 2 is a sectional view of an apparatus for producing a transparent conductive film according to one embodiment of this invention. In the figure, numeral 1 denotes a vacuum chamber, i.e., a sputtering chamber. In this sputtering chamber 1, there are provided three openings, i.e., an exhaust port 2, a loading port 3 and an unloading port 4. The exhaust port 2 is communicated with an evacuating means 6 such as a cryopump or the like via a valve 5 so that the sputtering chamber 1 can be adjusted in its vacuum degree by the evacuating means 6.

The loading port 3 is communicated with a loading chamber 8 via a valve 7. This loading chamber 8 is also provided at its loading port with a valve 9. The sputtering chamber 1 is communicated with a sputtering gas supply source 30, from which a sputter gas such, for example, as argon and oxygen is supplied independently or as a mixture gas through stop valves 31, mass flow controllers 32 and a nozzle 33. The partial pressures of the above-described argon gas and oxygen gas are respectively controlled for setting to the order, for example, of 0.113 Pa (10⁻³ Torr) with argon gas and 0.001 Pa (10⁻⁵ Torr) with oxygen gas.

In the sputtering chamber 1, there are provided in parallely opposing relationship a substrate 11 supported on a substrate holder 10, and a sputter cathode 12. This substrate holder 10 is either fixed or so arranged as to be linearly movable inside the sputtering chamber 1 while maintaining a parallel relationship with the sputter cathode 12. Although not illustrated, a means for linearly driving the substrate holder as described above is also provided.

Behind the substrate 11, there is provided a heater 13 to control the substrate temperature in the film-forming process to a predetermined temperature. The sputter cathode 12 is water-cooled, and on the front surface thereof there is fixed a target 14 with a brading material. In the rear portion of the sputter cathode 12, there is disposed via an insulating plate 18 a cathode case 17 which contains therein a permanent magnet 16 supported on a pole piece 15. This permanent magnet 16 is for generating a magnetic field for magnetron discharging. The intensity of the magnetic field on the surface of the target 14 is adjusted by varying the distance between the permanent magnet 16 and the target 14, the intensity of the magnetic field being made adjustable up to a maximum of 1.273 x 10⁵ A/m (1600 Oe).

As an electric power supply for plasma discharging, a DC power supply means 19 as a main power supply and an RF (e.g., 13.56MHz) power supply means 20 as an auxiliary power supply are used. The DC power supply means 19 is connected, via an RF filter 21 for preventing the incoming RF electric field, and the RF power supply means 20 is connected via a matching box 22, respectively to the cathode case 17 and further to the sputter cathode 12. The sputtering chamber 1 is grounded as shown by numeral 23. It is thus so arranged that, by making the sputtering chamber 1 to be at earth potential, the cathode case 17 is charged with a negative voltage so that DC magnetron sputtering can be carried out inside the vacuum chamber 1.

The unloading port 4 of the vacuum chamber 1 is communicated with an unloading chamber 25 via a valve 24. This unloading chamber 25 is also provided at its unloading port with a valve 26.

The substrate 11 is mounted on the substrate holder 10 from the side of the loading chamber 8, and the substrate having formed a transparent conductive film on the surface thereof is unloaded from the side of the unloading chamber 25.

In the figure, numeral 27 denotes an anti-deposition plate and numeral 29 denotes an earth shield.

### Experiment Example 1

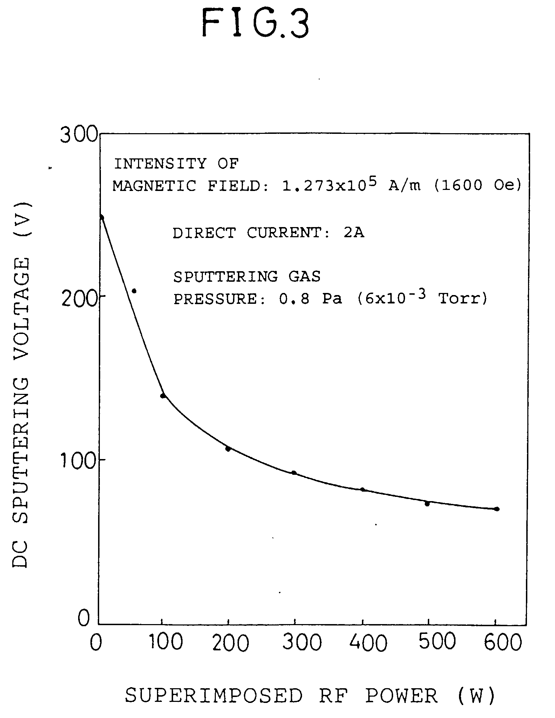

In the apparatus as shown in Fig. 2, a sintered target of In₂O₃ with an addition of 10% by weight of SnO₂ was used. The distance between the target and the substrate was set at 80mm, and the intensity of the magnetic field was set at 1.273 x 10⁵ A/m (1600 Oe), and the DC power supply was controlled to maintain a constant current supply of 2A. Under the above conditions, an RF electric field of 13.56MHz was superimposed, while varying the electric power, on the discharging by the DC electric field. The DC sputtering voltage at this time was measured. In this experiment example, as a sputtering gas, a mixture gas of argon and oxygen was introduced into the sputtering chamber 1, and the total pressure therein was adjusted to 0.8 Pa (6 x 10⁻³ Torr). The results are shown in Fig. 3. As can be seen from the graph in Fig. 3, as compared with the sputtering voltage of 250V at the time without superimposition of high-frequency electric field, the sputtering voltage lowered or decreased with an increase in the RF electric power when the high-frequency electric field was charged by superimposition. The sputtering voltage lowered down to 70V at the time of superimposition of RF electric power of 600W.

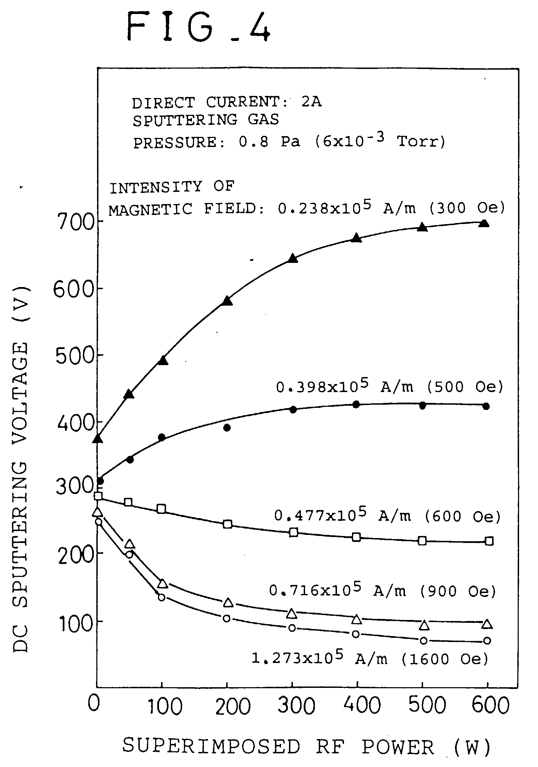

The DC sputtering voltage was also measured when the intensity of the magnetic field was varied within the range of 0.238 x 10⁵ and 1.273x10⁵ A/m (300 and 1600 Oe) and, at the same time, when the RF electric field was charged by superimpostion while varying the electric power. The results are shown in Fig. 4. As can be seen from the graph of this figure, when the intensity of the magnetic field was 0.477x10⁵ A/m (600 Oe) or greater, the DC sputtering voltage lowered by the superimposition of the RF electric field. However, when the intensity of the magnetic field was 0.398 x 10⁵ A/m (500 Oe) or below, the sputtering voltage increased as a result of the superimposition of the RF electric field. Therefore, in order to lower the sputtering voltage by superimposing the RF electric field, the intensity of the magnetic field on the surface of the target must be maintained at 0.477 x 10⁵ A/m (600 Oe) or greater.

### Experiment Example 2

Inside the sputtering chamber 1 of the above-described apparatus, there were disposed an oxide target 14 (125mm x 406mm in size) of In₂O₃ with an addition of 10% by weight of SnO₂ and a substrate 11 made of a transparent glass (No. 7059 of Corning Co. make, 1.1mm in thickness). As a sputtering gas, a mixture gas of argon and oxygen was introduced into the sputtering chamber 1, and the total pressure therein was adjusted to 0.8 Pa (6 x 10⁻³ Torr). The sputtering voltage was varied, in the range of 250V and more, only by varying the intensity of the magnetic field. Since the intensity of the magnetic field was 1.273 x 10⁵ A/m (1600 Oe) at the sputtering voltage of 250V, the sputtering voltage was varied in the range of 250V or less by superimposing the RF electric field while maintaining the intensity of the magnetic field at 1.273 x 10⁵ A/m (1600 Oe).

Here, since a most optimum value of the electrical resistivity of the ITO film is dependent on the conditions of partial pressure of oxygen, the electrical resistivity of the ITO film was measured by varying the partial pressure of oxygen in the order of 0.001 Pa (10⁻⁵ Torr) under the respective conditions, and a most optimum value was selected.

Film forming was carried out by moving the substrate from the side of the loading port 3 towards the side of the unloading port 4 at an equal speed, while maintaining the substrate temperature at 200°C under the above-described conditions.

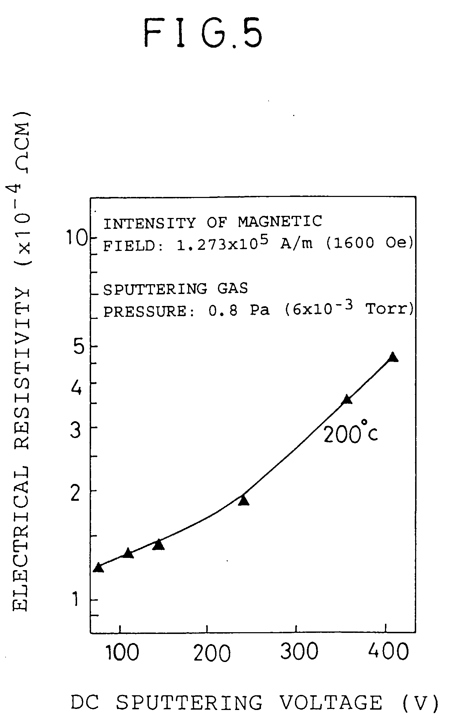

Fig. 5 shows the relationship between the sputtering voltage and the electrical resistivity of the ITO film obtained. As can be seen from this figure, there were obtained the electrical resistivities of the ITO film of as low as 1.9 x 10⁻⁴ Ω cm at the sputtering voltage of 250V and 1.25 x 10⁻⁴ Ω cm by still further lowering the voltage to 80V, as compared with 4.5 x 10⁻⁴ Ω cm at the sputtering voltage of 420V.

The reason for these low sputtering voltages is considered to be as follows. Namely, in this method of producing a transparent conductive film, by sputtering at a low sputtering voltage of 250V or less, i.e., at a target voltage of -250V or less, that energy of the anions incident on the transparent conductive film which gives damages thereto and which causes the rise in the electric resistance, is reduced or decreased. As a consequence, in the ITO film, for instance, divalent In or Sn which serves as an acceptor decreases and the carrier density increases, thereby lowering the electrical resistivity of the ITO film.

In the above embodiment, an explanation was made about a case in which an ITO based target was used. As a target, an SnO based or a ZnO based sintered body may also be used as well. When a transparent conductive film is formed by using this SnO based or ZnO based sintered body, the electric resistance is deteriorated by the incidence of the anions of oxygen or the like. However, the electrical resistivity of the formed transparent conductive film can be lowered by lowering the sputtering voltage, like in the case of using the above-described ITO based target.

According to this invention, as described above, since it is possible to decrease that incident energy of the anions which may give rise to the increase in the resistance of the transparent conductive film, a transparent conductive film of a lower resistance than that of the conventional sputtering method can be obtained.

For example, when an ITO transparent conductive film was produced on a substrate of 200°C, in the conventional sputtering method (sputtering voltage about 400V) it was only possible to obtain a transparent conductive film with an electrical resistivity in the order of 4 to 5 x 10⁻⁴Ωcm. On the contrary, when this invention was used, it was possible to obtain a transparent conductive film with as low an electrical resistivity as about 1.25 x 10⁻⁴Ωcm, i.e., about 1/3 of the value in the conventional method.

It is readily apparent that the above-described has the advantage of wide commercial utility. It should be understood that the specific form of the invention hereinabove described is intended to be representative only, as certain modifications within the scope of these teachings will be apparent to those skilled in the art.

Accordingly, reference should be made to the following claims in determining the full scope of the invention.

## Claims

1. A method of producing an In-O, Sn-O, Zn-O, Cd-Sn-O or Cd-In-O based transparent conductive film with an optional addition of a donor element, said method comprising the steps of:
maintaining an intensity of a magnetic field on a surface of a target (14) at a level of at least 0.477 · 10⁵ A/m (600 Oe); and
sputtering the target (14) so as to form the transparent conductive film on a substrate (11) by charging the target, simultaneously with said maintaining of the magnetic field intensity, with a DC electric field superimposed with an RF electric field so as to lower the sputtering voltage to 250 volts or less.

2. An apparatus for producing an In-O, Sn-O, Zn-O, Cd-Sn-O or Cd-In-O based transparent conductive film with an optional addition of a donor element, said apparatus comprising:
a vacuum chamber (1) adapted to support therein a substrate (11) and a target (14) in opposed relationship to each other for forming by sputtering the transparent conductive film on the substrate (11) by plasma discharge generated therebetween;
means (16) for forming a magnetic field having a predetermined intensity of 0,477 · 10⁵ A/m (600 Oe) or greater on a surface of the target (14); and
power supply means for sputtering used in forming the transparent conductive film, said power supply means including DC power supply means (19) for supplying the target with a DC electric field, and RF power supply means (20) for superimposing an RF electric field on the DC electric field, said power supply means (19,20) so constructed and arranged as to supply an electric field to the target (14) by superimposing the RF electric field on the DC electric field while maintaining a sputtering voltage during formation of the transparent conductive film at 250 volts or less.

## Patentansprüche

1. Verfahren zum Herstellen eines auf In-O, Sn-O, Zn-O, Cd-Sn-O oder Cd-In-O basierenden durchsichtigen leitfähigen Films mit einer wahlweisen Zugabe eines Donatorelements, umfassend die Schritte:
Aufrechterhalten einer Intensität eines Magnetfeldes auf einer Oberfläche eines Targets (14) auf einen Wert von mindestens 0,477x10⁵A/m (6000e), und
Sputtern des Targets (14), um auf einem Substrat (11) den durchsichtigen leitfähigen Film auszubilden, indem gleichzeitig mit dem Aufrechterhalten der Magnetfeldintensität dem Target ein elektrisches Gleichstromfeld, welches mit einem elektrischen Hochfrequenzfeld zur Verringerung der Sputterspannung auf 250 Volt oder niedriger überlagert ist, zugeführt wird.

2. Vorrichtung zum Herstellen eines auf In-O, Sn-O, Cd-Sn-O oder Cd-In-O basierenden durchsichtigen leitfähigen Films mit einer wahlweisen Zugabe eines Donatorelementes, umfassend:
eine Vakuumkammer (1), die zur Aufnahme eines Substrats (11) und eines Targets (14) in gegenüberliegender Anordnung darin geeignet ist, um auf dem Substrat (11) durch Sputtern den durchsichtigen leitfähigen Film durch eine Plasmaentladung zwischen dem Target (14) und dem Substrat (11) auszubilden,
Mittel (16) zum Erzeugen eines Magnetfeldes mit einer bestimmten Intensität von mindestens 0,477x10⁵A/m (6000e) auf der Oberfläche des Targets (14), und
Stromversorgungsmittel zum Sputtern, die zum Ausbilden des durchsichtigen leitfähigen Films verwendet werden, wobei die Stromversorgungsmittel Gleichstromversorgungsmittel (19) umfassen, um dem Target (14) ein elektrisches Gleichstromfeld zuzuführen, sowie Hochfrequenz-Stromversorgungsmittel (20) zum Überlagern des elektrischen Gleichstromfeldes mit einem elektrischen Hochfrequenzfeld., wobei die Stromversorgungsmittel (19, 20) derart ausgebildet und angeordnet sind, daß das Target einem elektrischen Feld ausgesetzt wird, indem das elektrische Gleichstromfeld mit dem elektrischen Hochfrequenzfeld überlagert wird, während eine Sputterspannung bei der Ausbildung des durchsichtigen leitfähigen Films auf höchstens 250 Volt gehalten wird.

## Revendications

1. Procédé pour fabriquer une pellicule conductrice transparente à base de In-O, Sn-O, Zn-O, Cd-Sn-O ou Cd-In-O avec une addition facultative d'un élément donneur, ledit procédé comprenant les étapes de :
maintien d'une intensité d'un champ magnétique sur une surface d'une cible (14) à un niveau d'au moins 0,477·10⁵ A/m (600 Oe) ; et
pulvérisation cathodique de la cible (14) de façon à former la pellicule conductrice transparente sur un substrat (11) en appliquant à la cible, simultanément avec ledit maintien de l'intensité du champ magnétique, un champ électrique CC superposé avec un champ électrique RF de façon à abaisser la tension de pulvérisation cathodique à 250 V ou moins.

2. Appareil pour fabriquer une pellicule conductrice transparente à base de In-O, Sn-O, Zn-O, Cd-Sn-O ou Cd-In-O avec une addition facultative d'un élément donneur, ledit appareil comprenant :
une enceinte sous vide (1) adaptée pour supporter un substrat (11) à l'intérieur de celle-ci et une cible (14) en relation opposée l'un par rapport à l'autre pour former, par pulvérisation cathodique, la pellicule conductrice transparente sur le substrat (11) par décharge de plasma produite entre ceux-ci ;
des moyens (16) pour former un champ magnétique ayant une intensité prédéterminée de 0,477·10⁵ A/m (600 Oe) ou plus sur une surface de la cible (14) ; et
des moyens d'alimentation en puissance pour la pulvérisation cathodique utilisée dans la formation de la pellicule conductrice transparente, lesdits moyens d'alimentation en puissance incluant un moyen d'alimentation en puissance CC (19) pour appliquer à la cible un champ électrique CC, et un moyen d'alimentation en puissance RF (20) pour superposer un champ électrique RF sur le champ électrique CC, lesdits moyens d'alimentation en puissance (19, 20) étant construits et arrangés de façon à fournir un champ électrique à la cible (14) en superposant le champ électrique RF sur le champ électrique CC tout en maintenant une tension de pulvérisation cathodique pendant la formation de la pellicule conductrice transparente à 250 V ou moins.
